# EUROPEAN PATENT SPECIFICATION

(11) **EP 4 579 261 B1**
(45) Date of publication and mention of the grant of the patent: **16.09.2026**
(21) Application number: 23907637.5
(22) Date of filing: 15.12.2023
(51) Int. Cl.: G01R 31/36, G01R 31/367, G01R 31/392, G01R 31/378

(54) **APPARATUS AND METHOD FOR DIAGNOSING BATTERY**
VORRICHTUNG UND -VERFAHREN ZUR BATTERIEDIAGNOSE
APPAREIL ET PROCÉDÉ DE DIAGNOSTIC DE BATTERIE

(30) Priority: 23.12.2022 KR 20220183779
(43) Date of publication of application: 02.07.2025
(73) Proprietor: LG Energy Solution, Ltd., Seoul 07335 (KR)
(72) Inventor: KIM, Young-Jin, Daejeon 34122 (KR)
(74) Representative: Plasseraud IP
(86) International application number: PCT/KR2023/020825
(87) International publication number: WO 2024/136352

(56) References cited:
- EP-A1- 4 155 748
- WO-A1-2022/055264
- KR-A- 20130 142 884
- KR-A- 20210 023 695
- KR-A- 20210 023 695
- KR-A- 20220 032 471
- KR-A- 20220 033 350
- KR-B1- 102 148 204

## Description

### TECHNICAL FIELD

The present application claims priority to Korean Patent Application No. 10-2022-0183779 filed on December 23, 2022 in the Republic of Korea.

The present disclosure relates to an apparatus and method for diagnosing a battery, and more particularly, to an apparatus and method for diagnosing a battery, which is capable of diagnosing a state of a battery.

### BACKGROUND ART

Recently, the demand for portable electronic products such as notebook computers, video cameras and portable telephones has increased sharply, and electric vehicles, energy storage batteries, robots, satellites and the like have been developed in earnest. Accordingly, high-performance batteries allowing repeated charging and discharging are being actively studied.

Batteries commercially available at present include nickel-cadmium batteries, nickel hydrogen batteries, nickel-zinc batteries, lithium batteries and the like. Among them, the lithium batteries are in the limelight since they have almost no memory effect compared to nickel-based batteries and also have very low self-charging rate and high energy density.

Although much research is being done on these batteries in terms of increasing capacity and density, improvements in lifespan and safety are also important. In order to improve battery safety, technology to accurately diagnose the current state of the battery is required.

### DISCLOSURE

### Technical Problem

The present disclosure is designed to solve the problems of the related art, and therefore the present disclosure is directed to providing an apparatus and method for diagnosing a battery, which may diagnose a state of a battery more accurately by reflecting a long-term trend of the battery.

These and other objects and advantages of the present disclosure may be understood from the following detailed description and will become more fully apparent from the exemplary embodiments of the present disclosure. Also, it will be easily understood that the objects and advantages of the present disclosure may be realized by the means shown in the appended claims and combinations thereof.

An example of prior art can be found in document WO 2022/055264 A1.

### Technical Solution

An apparatus for diagnosing a battery according to one aspect of the present invention is defined in claim 1. A battery pack according to another aspect of the present disclosure is also provided. A method for diagnosing a battery according to still another aspect of the present invention is also provided in claim 10.

### Advantageous Effects

According to one aspect of the present disclosure, the apparatus for diagnosing a battery may diagnose the state of the battery based on the normalization value of the battery profile corresponding to a plurality of cycles. In other words, the apparatus for diagnosing a battery may more accurately diagnose the state of the battery by reflecting the long-term trend for the battery.

The effects of the present disclosure are not limited to the effects mentioned above, and other effects not mentioned will be clearly understood by those skilled in the art from the description of the claims.

### DESCRIPTION OF DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.
FIG. 1 is a diagram schematically showing an apparatus for diagnosing a battery according to an embodiment of the present disclosure.
FIG. 2 is a diagram schematically showing a battery profile for each cycle of a first battery according to an embodiment of the present disclosure.
FIG. 3 is a diagram schematically showing a correction profile for each cycle of the first battery according to an embodiment of the present disclosure.
FIG. 4 is a diagram schematically showing a standard score for each cycle of the first battery according to an embodiment of the present disclosure.
FIG. 5 is a diagram schematically showing a kurtosis for each cycle of the first battery according to an embodiment of the present disclosure.
FIG. 6 is a diagram schematically showing a battery profile for each cycle of a second battery according to an embodiment of the present disclosure.
FIG. 7 is a diagram schematically showing a correction profile for each cycle of the second battery according to an embodiment of the present disclosure.
FIG. 8 is a diagram schematically showing a standard score for each cycle of the second battery according to an embodiment of the present disclosure.
FIG. 9 is a diagram schematically showing a kurtosis for each cycle of the second battery according to an embodiment of the present disclosure.
FIG. 10 is a diagram schematically showing an exemplary configuration of a battery pack according to another embodiment of the present disclosure.
FIG. 11 is a diagram schematically showing an exemplary configuration of a vehicle according to still another embodiment of the present disclosure.
FIG. 12 is a diagram schematically showing a method for diagnosing a battery according to still another embodiment of the present disclosure.

### BEST MODE

The description proposed herein is just a preferable example for the purpose of illustrations only, not intended to limit the scope of the disclosure, so it should be understood that other modifications could be made thereto without departing from the scope of the disclosure.

Additionally, in describing the present disclosure, when it is deemed that a detailed description of relevant known elements or functions renders the key subject matter of the present disclosure ambiguous, the detailed description is omitted herein.

The terms including the ordinal number such as "first", "second" and the like, may be used to distinguish one element from another among various elements, but not intended to limit the elements by the terms.

Throughout the specification, when a portion is referred to as "comprising" or "including" any element, it means that the portion may include other elements further, without excluding other elements, unless specifically stated otherwise.

In addition, throughout the specification, when a portion is referred to as being "connected" to another portion, it is not limited to the case that they are "directly connected", but it also includes the case where they are "indirectly connected" with another element being interposed between them.

Hereinafter, a preferred embodiment of the present disclosure will be described in detail with reference to the accompanying drawings.

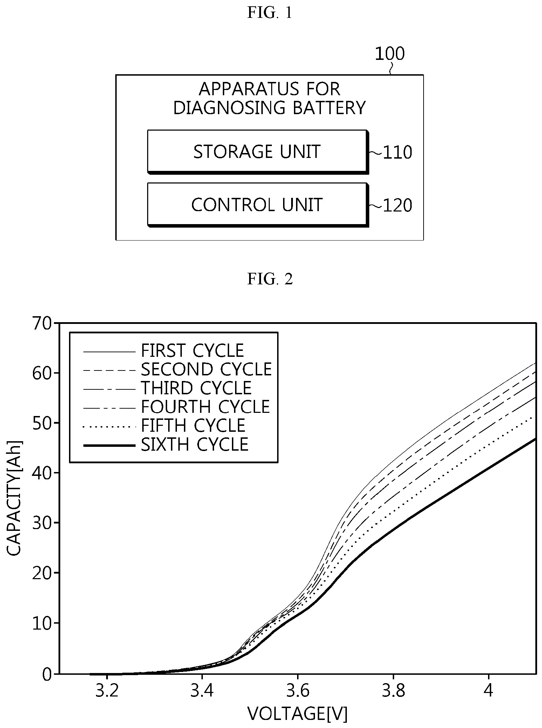

FIG. 1 is a diagram schematically illustrating an apparatus 100 for diagnosing a battery according to an embodiment of the present disclosure.

Referring to FIG. 1, the apparatus 100 for diagnosing a battery according to an embodiment of the present disclosure may include a storage unit 110 and a control unit 120.

Here, the battery refers to an independent cell that has a negative electrode terminal and a positive electrode terminal and is physically separable. As an example, a lithium-ion cell or a lithium polymer cell may be considered a battery. Hereinafter, for convenience of explanation, the battery is explained as meaning one independent cell.

The storage unit 110 may be configured to store a plurality of battery profiles that correspond to a plurality of cycles and represent the corresponding relationship between voltage and capacity of a battery.

Specifically, the battery profile obtained from each of the plurality of cycles may be stored in the storage unit 110. For example, if N cycles have been performed, N battery profiles may be stored in the storage unit 110. Here, the cycle may mean a charging and discharging cycle. Preferably, the cycle may mean a charging cycle.

FIG. 2 is a diagram schematically showing a battery profile for each cycle of a first battery according to an embodiment of the present disclosure. For example, the battery profile may be expressed as an X-Y graph with the X-axis set to voltage and the Y-axis set to capacity.

In the embodiment of FIG. 2, a plurality of battery profiles obtained in each of the first to sixth cycles are shown. For example, the first cycle is 2 cycles, the second cycle is 62 cycles, and the third cycle is 190 cycles. The fourth cycle is 329 cycles, the fifth cycle is 547 cycles, and the sixth cycle is 857 cycles. A battery profile representing the corresponding relationship between the voltage and capacity of the first battery obtained in each cycle may be stored in the storage unit 110.

The control unit 120 may be configured to generate a plurality of correction profiles representing the corresponding relationship between voltage and capacity change amount based on the plurality of battery profiles.

Here, the correction profile may be a profile representing the corresponding relationship between the battery voltage and capacity change amount. In other words, the battery profile is a profile for voltage and capacity, but the correction profile may be a profile for voltage and capacity change amount. That is, the control unit 120 may calculate the capacity change amount from the battery profile and generate a correction profile representing the corresponding relationship between the calculated capacity change amount and voltage.

Specifically, the control unit 120 may be configured to calculate the capacity change amount for the voltage of each of the plurality of battery profiles by calculating the capacity difference for the voltage of a preset reference profile and each of the plurality of battery profiles.

Here, the reference profile may be set as a battery profile for a battery in a BOL (Beginning of Life) state. For example, the reference profile may be a battery profile theoretically set to reflect the BOL state of the battery. As another example, the reference profile may be a battery profile corresponding to the first cycle among the plurality of battery profiles stored in the storage unit 110. Hereinafter, the description will be made assuming that the battery profile corresponding to the first cycle of the embodiment of FIG. 2 is set as the reference profile.

Specifically, the control unit 120 may calculate the capacity change amount by calculating the formula "Qᵢⱼ - Q₁ⱼ" for each voltage. Here, i is the cycle index and j is the voltage index. Qᵢⱼ is the capacity corresponding to voltage j of the battery profile corresponding to i cycle, and Q₁ⱼ is the capacity corresponding to voltage j of the reference profile. That is, the control unit 120 may calculate the capacity change amount by calculating the difference between the capacity of the battery profile and the capacity of the reference profile for each voltage.

The control unit 120 may be configured to generate a plurality of correction profiles according to the calculated capacity change amount and voltage.

In the embodiment of FIG. 2, it is assumed that the battery profile corresponding to the first cycle is the reference profile. The control unit 120 may generate a plurality of correction profiles by calculating the difference in capacity for each voltage between the reference profile and the battery profile corresponding to the first to sixth cycles.

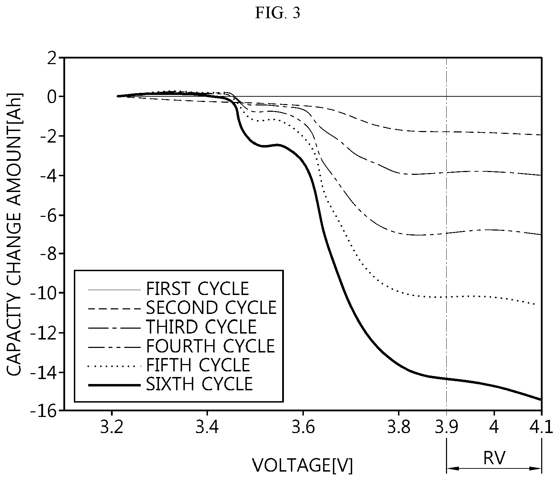

FIG. 3 is a diagram schematically showing a correction profile for each cycle of the first battery according to an embodiment of the present disclosure. For example, the correction profile may be expressed as an X-Y graph with the X-axis set to voltage and the Y-axis set to capacity change amount.

The embodiment of FIG. 3 may be a plurality of correction profiles for the plurality of battery profiles according to the embodiment of FIG. 2. For example, it may be a plurality of correction profiles generated for a plurality of battery profiles based on a reference profile (battery profile corresponding to the first cycle). Here, since the reference profile is set to the battery profile corresponding to the first cycle, the capacity change amount of the correction profile corresponding to the first cycle in the embodiment of FIG. 3 may be 0 [Ah].

The control unit 120 may be configured to calculate a normalization value for the generated plurality of correction profiles.

Specifically, the control unit 120 may normalize the plurality of correction profiles using the average and standard deviation between the plurality of correction profiles. Also, the control unit 120 may calculate the normalization value for the plurality of correction profiles according to the normalization result. In other words, the normalization value may be a relative value that can be calculated from the plurality of correction profiles.

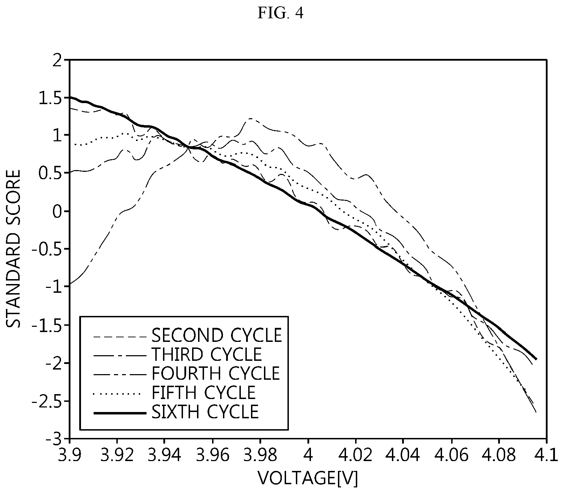

FIG. 4 is a diagram schematically showing a standard score for each cycle of the first battery according to an embodiment of the present disclosure. For convenience of explanation, the embodiment of FIG. 4 is a diagram showing the normalization value (standard score) calculated from 3.9 [V] to 4.1 [V], which is a preset voltage section RV.

Specifically, the control unit 120 may calculate a standard score for the plurality of correction profiles. The standard score is a dimensionless number that shows where each case occupies on the standard deviation in a statistical normal distribution, and may also be expressed as a standard value, Z value, or Z score.

For example, the control unit 120 may calculate a standard score for each capacity change amount using the average and standard deviation between the plurality of capacity change amounts (capacity change amounts of plurality of correction profiles for the corresponding voltage) for each voltage.

Note that in the example of FIG. 4, the standard score corresponding to the first cycle is excluded. That is, the embodiment of FIG. 4 is a diagram showing standard scores corresponding to the second to sixth cycles. Referring to FIG. 4, a standard score corresponding to each cycle at each voltage may be calculated.

After calculating the standard score for the plurality of correction profiles, the control unit 120 may calculate a kurtosis for the plurality of correction profiles based on the calculated standard score. Here, the kurtosis is a basic statistic that represents the shape of the distribution and may provide information about the length of the tail and the sharpness of the center of the distribution.

The control unit 120 may calculate the kurtosis for each cycle based on the plurality of standard scores calculated for each cycle. For example, the control unit 120 may calculate the kurtosis by calculating the average of the fourth square of the calculated plurality of standard scores for each cycle. If the standard score is expressed as Z, the kurtosis may be expressed as E[Z⁴].

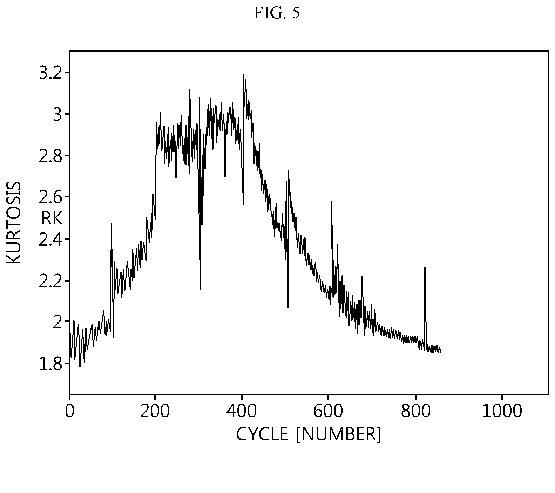

FIG. 5 is a diagram schematically showing a kurtosis for each cycle of the first battery according to an embodiment of the present disclosure. In the example of FIG. 5, the kurtosis for all cycles performed on the first battery is shown.

The control unit 120 may be configured to diagnose the state of the battery based on the calculated plurality of normalization values and a preset reference value RK.

Specifically, the reference value RK is a standard value for determining the state of the battery, and may be set based on experimental results for a test cell. For example, the test cell may be a cell in which lithium metal is induced to precipitate. The reference value RK may be determined based on the kurtosis of this test cell.

For example, if at least one of the plurality of normalization values is greater than or equal to the reference value RK, the control unit 120 may be configured to diagnose the state of the battery as a lithium precipitation state. As another example, if the plurality of normalization values are less than the reference value RK, the control unit 120 may be configured to diagnose the state of the battery as a normal state.

For example, in the embodiment of FIG. 5, the kurtosis for the first battery may be greater than or equal to the reference value RK after about 200 cycles. Therefore, the apparatus 100 for diagnosing a battery may diagnose the state of the first battery as a lithium precipitation state.

The apparatus 100 for diagnosing a battery according to an embodiment of the present disclosure may diagnose the state of the battery based on the normalization value for the battery profile corresponding to the plurality of cycles. In other words, the apparatus 100 for diagnosing a battery may more accurately diagnose the state of the battery by reflecting the long-term trend for the battery.

Meanwhile, the control unit 120 included in the apparatus 100 for diagnosing a battery may optionally include processors, application-specific integrated circuits (ASICs), other chipsets, logic circuits, registers, communication modems, data processing devices, etc. known in the art to execute various control logics performed in the present disclosure. Also, when the control logic is implemented as software, the control unit 120 may be implemented as a set of program modules. At this time, the program module may be stored in the memory and executed by the control unit 120. The memory may be inside or outside the control unit 120 and may be connected to the control unit 120 by various well-known means.

In addition, the storage unit 110 may store data necessary for operation and function of each component of the apparatus 100 for diagnosing a battery, data generated in the process of performing the operation or function, or the like. The storage unit 110 is not particularly limited in its kind as long as it is a known information storage means that can record, erase, update and read data. As an example, the information storage means may include RAM, flash memory, ROM, EEPROM, registers, and the like. In addition, the storage unit 110 may store program codes in which processes executable by the control unit 120 are defined.

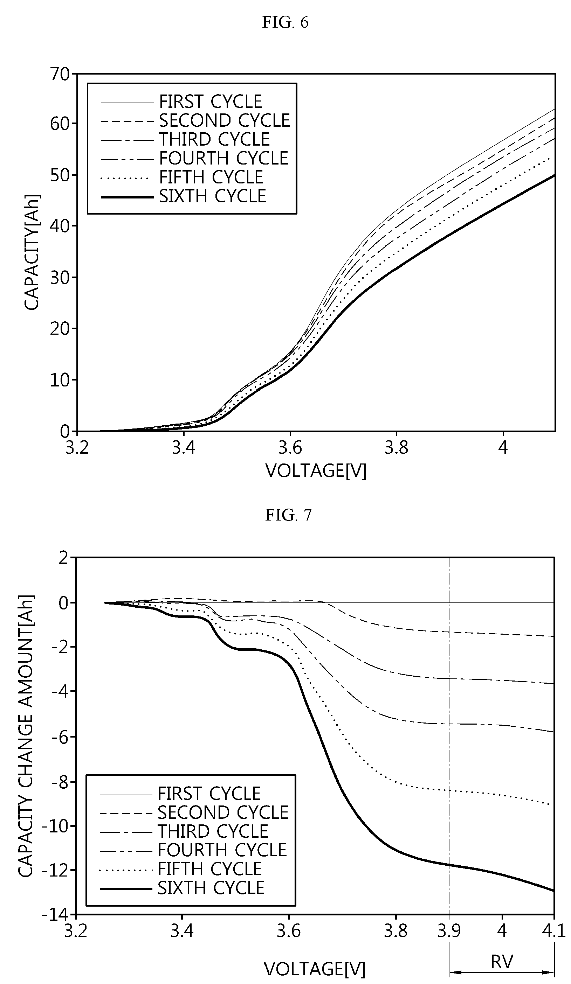

FIG. 6 is a diagram schematically showing a battery profile for each cycle of a second battery according to an embodiment of the present disclosure.

Like the embodiment of FIG. 2, in the embodiment of FIG. 6, the first cycle is 2 cycles, the second cycle is 62 cycles, and the third cycle is 190 cycles. The fourth cycle is 329 cycles, the fifth cycle is 547 cycles, and the sixth cycle is 857 cycles.

The storage unit 110 may store the battery profiles of the first to sixth cycles for the second battery.

FIG. 7 is a diagram schematically showing a correction profile for each cycle of the second battery according to an embodiment of the present disclosure.

The control unit 120 may generate a plurality of correction profiles from the plurality of battery profiles according to the embodiment of FIG. 6. The control unit 120 may set the battery profile corresponding to the first cycle in the embodiment of FIG. 6 as a reference profile and generate a correction profile corresponding to the first to sixth cycles based on the reference profile.

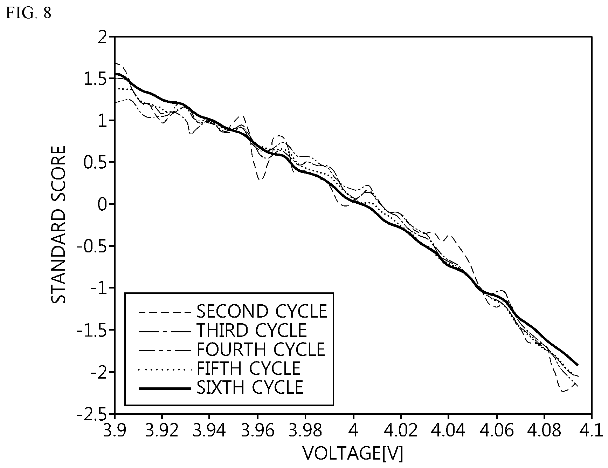

FIG. 8 is a diagram schematically showing a standard score for each cycle of the second battery according to an embodiment of the present disclosure. Note that, like the embodiment of FIG. 4, the standard score corresponding to the first cycle is excluded in the embodiment of FIG. 8.

The control unit 120 may calculate a standard score for each voltage corresponding to each cycle based on the correction profile corresponding to the first to sixth cycles of the second battery.

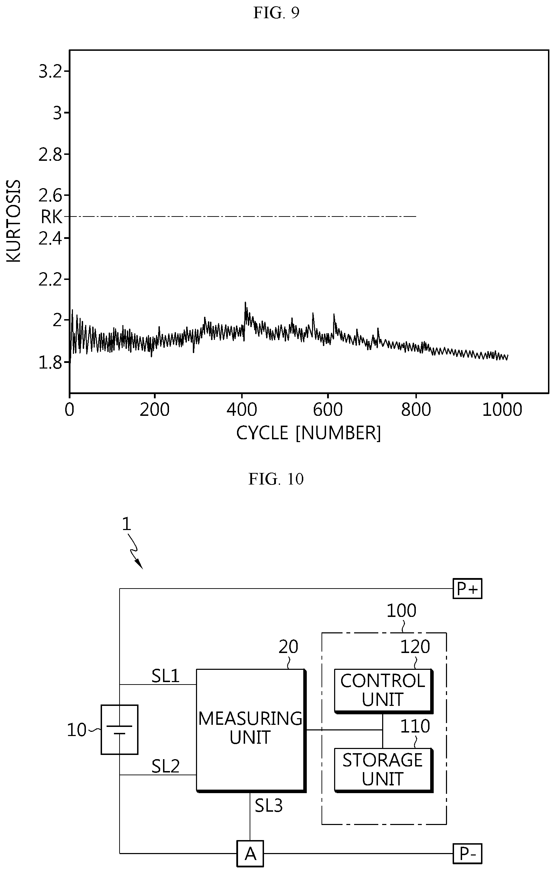

FIG. 9 is a diagram schematically showing a kurtosis for each cycle of the second battery according to an embodiment of the present disclosure. In the example of FIG. 9, the kurtosis for all cycles performed on the second battery is shown.

The control unit 120 may compare the reference value RK and the plurality of kurtosis of the second battery. Since the kurtosis of the second battery is less than the reference value RK in all cycles, the control unit 120 may diagnose the state of the second battery as a normal state.

The control unit 120 may be configured to calculate the normalization value of the capacity change amount for the preset voltage section RV in each of the plurality of correction profiles. For example, the control unit 120 may be configured to calculate the kurtosis of the preset voltage section RV as a normalization value with respect to the plurality of correction profiles.

Specifically, the control unit 120 may be configured to calculate the standard score only in the preset voltage section RV.

For example, referring to the embodiments of FIGS. 3 and 7, the capacity change amount of the first battery in the lithium precipitation state increases in the preset voltage section RV, but the capacity change amount of the second battery in the normal state does not increase in the preset voltage section RV. In other words, when lithium metal is precipitated on the negative electrode surface, an abnormal phenomenon occurs in which the capacity change amount increases in the preset voltage section RV. Therefore, the control unit 120 may calculate the normalization value for the preset voltage section RV from the battery profile, considering the characteristics of the battery in the lithium precipitation state.

Specifically, the control unit 120 may calculate a standard score for each voltage in the preset voltage section RV of plurality of correction profiles, and calculate a kurtosis for each cycle according to the calculated standard score.

The apparatus 100 for diagnosing a battery has the advantage of efficiently using system resources and quickly diagnosing the state of the battery by performing battery diagnosis based on the voltage section that can distinguish the lithium precipitation state and the normal state.

Below, a specific embodiment in which the control unit 120 calculates kurtosis from each of the plurality of correction profiles will be described.

First, the control unit 120 may be configured to calculate a standard score of the capacity change amount for each voltage of the preset voltage section RV from the plurality of correction profiles.

Specifically, the control unit 120 may be configured to select a capacity change amount corresponding to each voltage from the plurality of correction profiles.

For example, assume that the target voltage is Vj, and the capacity change rate corresponding to the target voltage is △Qij, where i is the cycle index and j is the voltage index. In the embodiment of FIG. 3, the control unit 120 may select △Q1j, △Q2j, △Q3j, △Q4j, △Q5j, and △Q6j from the first to sixth correction profiles.

The control unit 120 may be configured to calculate a standard score of the selected plurality of capacity change amounts for each of the plurality of correction profiles.

For example, control unit 120 may calculate standard scores for the selected △Q1j, △Q2j, △Q3j, △Q4j, △Q5j, and △Q6j. That is, the control unit 120 may calculate a standard score for the plurality of capacity change rates at each voltage. Here, since the method of calculating the standard score uses a known method, detailed formulas and explanations are omitted here.

Next, the control unit 120 may be configured to calculate the kurtosis of each of the plurality of correction profiles based on the standard score calculated for each of the plurality of correction profiles.

For example, when standard score calculation is completed in the preset voltage section RV of the plurality of correction profiles, a standard score for each voltage may be set for each cycle. The control unit 120 may calculate the kurtosis of each cycle based on the plurality of standard scores corresponding to each cycle.

In the embodiment of FIG. 4, the control unit 120 may calculate kurtosis of the fourth cycle based on the plurality of standard scores corresponding to the fourth cycle.

That is, each standard score is calculated based on the capacity change amount of the plurality of correction profiles, but kurtosis may be calculated based on the standard scores of the corresponding cycle.

If a new battery profile is additionally stored in the storage unit 110, the control unit 120 may be configured to diagnose the state of the battery based on all battery profiles stored in the storage unit 110.

The standard score may be calculated based on the capacity change amount of plurality of correction profiles. In other words, if a plurality of correction profiles are added, the capacity change amount, which is the basis for calculating the standard score, may also be added. In this case, since the standard score for each cycle for the corresponding voltage is calculated based on all capacity change amounts, the control unit 120 may re-diagnose the state of the battery to consider the change trend in the battery state.

In other words, since the apparatus 100 for diagnosing a battery re-diagnoses the state of the battery every time more battery profiles are stored, it is possible to diagnose the state of the battery more accurately by reflecting the long-term trend for the battery.

The apparatus 100 for diagnosing a battery according to the present disclosure may be applied to a battery management system (BMS). That is, the BMS according to the present disclosure may include the apparatus 100 for diagnosing a battery described above. In this configuration, at least some of components of the apparatus 100 for diagnosing a battery may be implemented by supplementing or adding functions of the components included in a conventional BMS. For example, the storage unit 110 and the control unit 120 of the apparatus 100 for diagnosing a battery may be implemented as components of the BMS.

Additionally, the apparatus 100 for diagnosing a battery according to the present disclosure may be provided in the battery pack. That is, the battery pack according to the present disclosure may include the above-described apparatus 100 for diagnosing a battery and at least one battery cell. Additionally, the battery pack may further include electrical components (relays, fuses, etc.) and a case.

FIG. 10 is a diagram schematically showing an exemplary configuration of a battery pack according to another embodiment of the present disclosure.

The positive electrode terminal of the battery 10 may be connected to the positive electrode terminal P+ of the battery pack 1, and the negative electrode terminal of the battery 10 may be connected to the negative electrode terminal P- of the battery pack 1.

The measuring unit 20 may be connected to a first sensing line SL1, a second sensing line SL2 and a third sensing line SL3. Specifically, the measuring unit 20 may be connected to the positive electrode terminal of the battery 10 through the first sensing line SL1, and may be connected to the negative electrode terminal of the battery 10 through the second sensing line SL2. The measuring unit 20 may measure the voltage of the battery 10 based on the voltage measured at each of the first sensing line SL1 and the second sensing line SL2.

In addition, the measuring unit 20 may be connected to the current measurement unit A through the third sensing line SL3. For example, the current measurement unit A may be an ammeter or shunt resistor that may measure the charging current and discharging current of the battery 10. The measuring unit 20 may calculate the charging amount by measuring the charging current of the battery 10 through the third sensing line SL3. Additionally, the measuring unit 20 may calculate the discharging amount by measuring the discharging current of the battery 10 through the third sensing line SL3.

An external device may can be connected to the positive terminal P+ and negative terminal P- of the battery pack 1. Here, the external device may be a charging device that can the charge battery 10, or it may be a load that receives power from the battery 10.

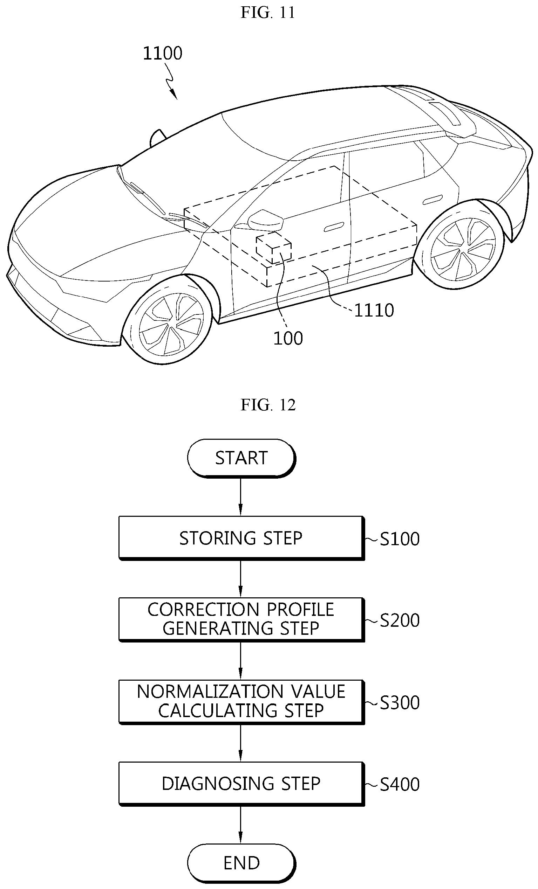

FIG. 11 is a diagram schematically showing a vehicle 1100 according to another embodiment of the present disclosure.

Referring to FIG. 11, the battery pack 1110 according to an embodiment of the present disclosure may be included in the vehicle 1100 such as an electric vehicle (EV) or a hybrid vehicle (HV). Additionally, the battery pack 1110 may drive the vehicle 1100 by supplying power to the motor through an inverter provided in the vehicle 1100. Additionally, the battery pack 1110 may include the apparatus 100 for diagnosing a battery.

FIG. 12 is a diagram schematically showing a method for diagnosing a battery according to still another embodiment of the present disclosure.

Preferably, each step of the method for diagnosing a battery may be performed by the apparatus 100 for diagnosing a battery. Hereinafter, for convenience of explanation, the content overlapping with the previously described content will be briefly described or omitted.

The method for diagnosing a battery may include a storing step (S100), a correction profile generating step (S200), a normalization value calculating step (S300), and a diagnosing step (S400).

The storing step (S100) is a step of storing a plurality of battery profiles that correspond to a plurality of cycles and represent the corresponding relationship between voltage and capacity of a battery, and may be performed by the storage unit 110.

Specifically, the storage unit 110 may store a battery profile obtained from each of the plurality of cycles. For example, if N cycles have been performed, N battery profiles may be stored in the storage unit 110.

For example, in the embodiment of FIG. 2, six battery profiles corresponding to the first to sixth cycles may be stored in the storage unit 110.

The correction profile generating step (S200) is a step of generating a plurality of correction profiles representing the corresponding relationship between voltage and capacity change amount based on the plurality of battery profiles, and may be performed by the control unit 120.

For example, the control unit 120 may be configured to calculate the capacity change amount for each voltage of the plurality of battery profiles by calculating the capacity difference for the voltage of a preset reference profile and each of the plurality of battery profiles.

In the embodiment of FIG. 2, it is assumed that the battery profile corresponding to the first cycle is the reference profile. The control unit 120 may generate a plurality of correction profiles by calculating the difference in capacity for each voltage between the reference profile and the battery profiles corresponding to the first to sixth cycles. The generated plurality of correction profiles are shown in the embodiment of FIG. 3.

The normalization value calculating step (S300) is a step of calculating a normalization value for the generated plurality of correction profiles, and may be performed by the control unit 120.

For example, the control unit 120 may normalize the plurality of correction profiles using the average and standard deviation between the plurality of correction profiles. Also, the control unit 120 may calculate the normalization value for the plurality of correction profiles according to the normalization result.

In the embodiment of FIG. 4, the control unit 120 may calculate a standard score for each voltage in each cycle based on the plurality of correction profiles. Also, the control unit 120 may calculate kurtosis for each cycle. Here, the kurtosis may be the normalization value for each cycle.

The diagnosing step (S400) is a step of diagnosing the state of the battery based on the calculated plurality of normalization values and a preset reference value RK, and may be performed by the control unit 120.

For example, if at least one of the plurality of normalization values is greater than or equal to the reference value RK, the control unit 120 may be configured to diagnose the state of the battery as a lithium precipitation state. As another example, if the plurality of normalization values are less than the reference value RK, the control unit 120 may be configured to diagnose the state of the battery as a normal state.

The embodiments of the present disclosure described above may not be implemented only through an apparatus and a method, but may be implemented through a program that realizes a function corresponding to the configuration of the embodiments of the present disclosure or a recording medium on which the program is recorded. The program or recording medium may be easily implemented by those skilled in the art from the above description of the embodiments.

The present disclosure has been described in detail. However, it should be understood that the detailed description and specific examples, while indicating preferred embodiments of the disclosure, are given by way of illustration only, since various changes and modifications within the scope of the disclosure will become apparent to those skilled in the art from this detailed description.

Additionally, many modifications and changes may be made to the present disclosure described hereinabove by those skilled in the art without departing from the technical aspects of the present disclosure, and the present disclosure is not limited to the above-described embodiments and the accompanying drawings, and each embodiment may be selectively combined in part or in whole to allow various modifications.

### (Explanation of reference signs)

1: battery pack
10: battery
20: measuring unit
100: apparatus for diagnosing a battery
110: storage unit
120: control unit
1100: vehicle
1110: battery pack

## Claims

1. An apparatus for diagnosing a battery (100), comprising:
a storage unit (110) configured to store a plurality of battery profiles that correspond to a plurality of cycles and represent the corresponding relationship between voltage and capacity of a battery; and
a control unit (120) configured to generate a plurality of correction profiles representing the corresponding relationship between voltage and capacity change amount based on the plurality of battery profiles, **characterised in that** the control unit (120) is configured to calculate a respective normalization value for the generated plurality of correction profiles, and diagnose a state of the battery based on the calculated plurality of normalization values and a preset reference value.

2. The apparatus for diagnosing a battery according to claim 1,
wherein the control unit (120) is configured to:
diagnose the state of the battery as a lithium precipitation state when at least one of the plurality of normalization values is higher than or equal to the reference value, and
diagnose the state of the battery as a normal state when the plurality of normalization values are less than the reference value.

3. The apparatus for diagnosing a battery according to claim 1,
wherein the control unit (120) is configured to calculate a normalization value of the capacity change amount for a preset voltage section in each of the plurality of correction profiles.

4. The apparatus for diagnosing a battery according to claim 3,
wherein the control unit (120) is configured to calculate a kurtosis of the preset voltage section as the normalization value with respect to the plurality of correction profiles.

5. The apparatus for diagnosing a battery according to claim 4,
wherein the control unit (120) is configured to calculate a standard score of the capacity change amount for each voltage in the preset voltage section from the plurality of correction profiles, and calculate a kurtosis of each of the plurality of correction profiles based on the standard score calculated for each of the plurality of correction profiles.

6. The apparatus for diagnosing a battery according to claim 5,
wherein the control unit (120) is configured to select a capacity change amount corresponding to each voltage from the plurality of correction profiles and calculate a standard score of the selected plurality of capacity change amounts for each of the plurality of correction profiles.

7. The apparatus for diagnosing a battery according to claim 1,
wherein the control unit (120) is configured to calculate a capacity change amount for the voltage of each of the plurality of battery profiles by calculating a capacity difference for the voltage of a preset reference profile and each of the plurality of battery profiles, and generate the plurality of correction profiles according to the calculated capacity change amount and the voltage.

8. The apparatus for diagnosing a battery according to claim 1,
wherein the control unit (120) is configured to diagnose the state of the battery based on all battery profiles stored in the storage unit when a new battery profile is further stored in the storage unit.

9. A battery pack, comprising the apparatus for diagnosing a battery according to any one of claims 1 to 8.

10. A processor-implemented method for diagnosing a battery, comprising:
a storing step (S100) of storing a plurality of battery profiles that correspond to a plurality of cycles and represent the corresponding relationship between voltage and capacity of a battery;
a correction profile generating step (S200) of generating a plurality of correction profiles representing the corresponding relationship between voltage and capacity change amount based on the plurality of battery profiles;
**characterised by**
a normalization value calculating step (S300) of calculating a respective normalization value for the generated plurality of correction profiles; and
a diagnosing step (S400) of diagnosing a state of the battery based on the calculated plurality of normalization values and a preset reference value.

## Patentansprüche

1. Vorrichtung zur Diagnose einer Batterie (100), umfassend:
eine Speichereinheit (110), die konfiguriert ist, um eine Vielzahl von Batterieprofilen zu speichern, die einer Vielzahl von Zyklen entsprechen und die entsprechende Beziehung zwischen Spannung und Kapazität einer Batterie darstellen; und
eine Steuereinheit (120), die konfiguriert ist, um eine Vielzahl von Korrekturprofilen zu erzeugen, die die entsprechende Beziehung zwischen Spannung und Kapazitätsänderungsbetrag auf der Grundlage der Vielzahl von Batterieprofilen darstellen,
**dadurch gekennzeichnet, dass** die Steuereinheit (120) konfiguriert ist, um einen jeweiligen Normalisierungswert für die erzeugte Vielzahl von Korrekturprofilen zu berechnen und einen Zustand der Batterie auf der Grundlage der berechneten Vielzahl von Normalisierungswerten und eines voreingestellten Referenzwerts zu diagnostizieren.

2. Vorrichtung zur Diagnose einer Batterie nach Anspruch 1,
wobei die Steuereinheit (120) konfiguriert ist, um:
den Zustand der Batterie als einen Lithiumabscheidungszustand zu diagnostizieren, wenn mindestens einer der Vielzahl von Normalisierungswerten höher als oder gleich dem Referenzwert ist, und
den Zustand der Batterie als einen Normalzustand zu diagnostizieren, wenn die Vielzahl von Normalisierungswerten kleiner als der Referenzwert sind.

3. Vorrichtung zur Diagnose einer Batterie nach Anspruch 1,
wobei die Steuereinheit (120) konfiguriert ist, um einen Normalisierungswert des Kapazitätsänderungsbetrags für einen voreingestellten Spannungsabschnitt in jedem der Vielzahl von Korrekturprofilen zu berechnen.

4. Vorrichtung zur Diagnose einer Batterie nach Anspruch 3,
wobei die Steuereinheit (120) konfiguriert ist, um eine Kurtosis des voreingestellten Spannungsabschnitts als den Normalisierungswert in Bezug auf die Vielzahl von Korrekturprofilen zu berechnen.

5. Vorrichtung zur Diagnose einer Batterie nach Anspruch 4,
wobei die Steuereinheit (120) konfiguriert ist, um einen Standardwert des Kapazitätsänderungsbetrags für jede Spannung in dem voreingestellten Spannungsabschnitt aus der Vielzahl von Korrekturprofilen zu berechnen und eine Kurtosis jedes der Vielzahl von Korrekturprofilen auf der Grundlage des für jedes der Vielzahl von Korrekturprofilen berechneten Standardwerts zu berechnen.

6. Vorrichtung zur Diagnose einer Batterie nach Anspruch 5,
wobei die Steuereinheit (120) konfiguriert ist, um einen Kapazitätsänderungsbetrag, der jeder Spannung entspricht, aus der Vielzahl von Korrekturprofilen auszuwählen und einen Standardwert der ausgewählten Vielzahl von Kapazitätsänderungsbeträgen für jedes der Vielzahl von Korrekturprofilen zu berechnen.

7. Vorrichtung zur Diagnose einer Batterie nach Anspruch 1,
wobei die Steuereinheit (120) konfiguriert ist, um einen Kapazitätsänderungsbetrag für die Spannung jedes der Vielzahl von Batterieprofilen durch Berechnung einer Kapazitätsdifferenz für die Spannung eines voreingestellten Referenzprofils und jedes der Vielzahl von Batterieprofilen zu berechnen und die Vielzahl von Korrekturprofilen gemäß dem berechneten Kapazitätsänderungsbetrag und der Spannung zu erzeugen.

8. Vorrichtung zur Diagnose einer Batterie nach Anspruch 1,
wobei die Steuereinheit (120) konfiguriert ist, um den Zustand der Batterie auf der Grundlage aller in der Speichereinheit gespeicherten Batterieprofile zu diagnostizieren, wenn ein neues Batterieprofil zusätzlich in der Speichereinheit gespeichert wird.

9. Batteriepack, umfassend die Vorrichtung zur Diagnose einer Batterie nach einem der Ansprüche 1 bis 8.

10. Prozessorimplementiertes Verfahren zur Diagnose einer Batterie, umfassend:
einen Speicherschritt (S100) zum Speichern einer Vielzahl von Batterieprofilen, die einer Vielzahl von Zyklen entsprechen und die entsprechende Beziehung zwischen Spannung und Kapazität einer Batterie darstellen;
einen Korrekturprofil-Erzeugungsschritt (S200) zum Erzeugen einer Vielzahl von Korrekturprofilen, die die entsprechende Beziehung zwischen Spannung und Kapazitätsänderungsbetrag auf der Grundlage der Vielzahl von Batterieprofilen darstellen;
**gekennzeichnet durch**
einen Normalisierungswert-Berechnungsschritt (S300) zum Berechnen eines jeweiligen Normalisierungswerts für die erzeugte Vielzahl von Korrekturprofilen; und
einen Diagnoseschritt (S400) zum Diagnostizieren eines Zustands der Batterie auf der Grundlage der berechneten Vielzahl von Normalisierungswerten und eines voreingestellten Referenzwerts.

## Revendications

1. Un appareil pour diagnostiquer une batterie (100), comprenant :
une unité de stockage (110) configurée pour stocker une pluralité de profils de batterie qui correspondent à une pluralité de cycles et représentent la relation correspondante entre la tension et la capacité d'une batterie ; et
une unité de contrôle (120) configurée pour générer une pluralité de profils de correction représentant la relation correspondante entre la tension et la quantité de changement de capacité sur la base de la pluralité de profils de batterie,
**caractérisé en ce que** l'unité de contrôle (120) est configurée pour calculer une valeur de normalisation respective pour la pluralité générée de profils de correction, et diagnostiquer un état de la batterie sur la base de la pluralité calculée de valeurs de normalisation et d'une valeur de référence prédéfinie.

2. L'appareil pour diagnostiquer une batterie selon la revendication 1,
dans lequel l'unité de contrôle (120) est configurée pour :
diagnostiquer l'état de la batterie comme un état de précipitation du lithium lorsqu'au moins une de la pluralité de valeurs de normalisation est supérieure ou égale à la valeur de référence, et
diagnostiquer l'état de la batterie comme un état normal lorsque la pluralité de valeurs de normalisation sont inférieures à la valeur de référence.

3. L'appareil pour diagnostiquer une batterie selon la revendication 1,
dans lequel l'unité de contrôle (120) est configurée pour calculer une valeur de normalisation de la quantité de changement de capacité pour une section de tension prédéfinie dans chacun de la pluralité de profils de correction.

4. L'appareil pour diagnostiquer une batterie selon la revendication 3,
dans lequel l'unité de contrôle (120) est configurée pour calculer une kurtosis de la section de tension prédéfinie comme la valeur de normalisation par rapport à la pluralité de profils de correction.

5. L'appareil pour diagnostiquer une batterie selon la revendication 4,
dans lequel l'unité de contrôle (120) est configurée pour calculer un score standard de la quantité de changement de capacité pour chaque tension dans la section de tension prédéfinie à partir de la pluralité de profils de correction, et calculer une kurtosis de chacun de la pluralité de profils de correction sur la base du score standard calculé pour chacun de la pluralité de profils de correction.

6. L'appareil pour diagnostiquer une batterie selon la revendication 5,
dans lequel l'unité de contrôle (120) est configurée pour sélectionner une quantité de changement de capacité correspondant à chaque tension à partir de la pluralité de profils de correction et calculer un score standard de la pluralité sélectionnée de quantités de changement de capacité pour chacun de la pluralité de profils de correction.

7. L'appareil pour diagnostiquer une batterie selon la revendication 1,
dans lequel l'unité de contrôle (120) est configurée pour calculer une quantité de changement de capacité pour la tension de chacun de la pluralité de profils de batterie en calculant une différence de capacité pour la tension d'un profil de référence prédéfini et de chacun de la pluralité de profils de batterie, et générer la pluralité de profils de correction selon la quantité de changement de capacité calculée et la tension.

8. L'appareil pour diagnostiquer une batterie selon la revendication 1,
dans lequel l'unité de contrôle (120) est configurée pour diagnostiquer l'état de la batterie sur la base de tous les profils de batterie stockés dans l'unité de stockage lorsqu'un nouveau profil de batterie est en outre stocké dans l'unité de stockage.

9. Un bloc de batteries, comprenant l'appareil pour diagnostiquer une batterie selon l'une quelconque des revendications 1 à 8.

10. Un procédé mis en œuvre par processeur pour diagnostiquer une batterie, comprenant :
une étape de stockage (S100) consistant à stocker une pluralité de profils de batterie qui correspondent à une pluralité de cycles et représentent la relation correspondante entre la tension et la capacité d'une batterie ;
une étape de génération de profils de correction (S200) consistant à générer une pluralité de profils de correction représentant la relation correspondante entre la tension et la quantité de changement de capacité sur la base de la pluralité de profils de batterie ;
**caractérisé par**
une étape de calcul de valeur de normalisation (S300) consistant à calculer une valeur de normalisation respective pour la pluralité générée de profils de correction ; et
une étape de diagnostic (S400) consistant à diagnostiquer un état de la batterie sur la base de la pluralité calculée de valeurs de normalisation et d'une valeur de référence prédéfinie.
